# EUROPEAN PATENT APPLICATION

(11) **EP 2 557 897 A1**
(43) Date of publication of application: **13.02.2013**
(21) Application number: 11765418.6
(22) Date of filing: 24.03.2011
(51) Int. Cl.: H05B 33/10, H01L 51/50

(54) **METHOD OF MANUFACTURING LIGHT-EMITTING DEVICE**

(30) Priority: 31.03.2010 JP 2010081669
(71) Applicant: Sumitomo Chemical Company Limited, Tokyo 104-8260 (JP)
(72) Inventor: KAIHO Akio, Tsukuba-shi Ibaraki 305-0821 (JP)
(74) Representative: Jackson, Martin Peter
(86) International application number: PCT/JP2011/057187
(87) International publication number: WO 2011/125517

(57) **Abstract**

The present invention provides a manufacturing method of a light-emitting device including the steps of bringing a nozzle 13 that is communicated with a tank 14 for storing coating liquid 17 to be an organic electroluminescent (EL) layer and discharges the coating liquid 17 supplied from the tank 14 near a body-to-be-coated 19 that includes a support substrate arranged above the nozzle 13; bringing the coating liquid 17 discharged from the nozzle 13 in contact with the body-to-be-coated 19; and applying the coating liquid 17 to make a film thereof by relatively moving the body-to-be-coated 19 and the nozzle 13 in a state that the coating liquid 17 is in contact with the body-to-be-coated 19 to form the organic EL layer. After bringing the coating liquid 17 in contact with the body-to-be-coated 19 and before relatively moving the body-to-be-coated 19 and the nozzle 13, while maintaining the state that the coating liquid 17 is in contact with the body-to-be-coated 19, the tank 14 is lowered to below a position of the tank 14 for relative movement between the body-to-be-coated 19 and the nozzle 13 to be started, and then the tank 14 is raised back to the position of the tank 14 for the relative movement between the body-to-be-coated 19 and the nozzle 13 to be started. Thus, a manufacturing method of a light-emitting device is provided that can form an organic EL layer in which unevenness of the film thickness is suppressed by a capillary coating method.

## Description

### Technical Field

The present invention relates to a method of manufacturing a light-emitting device.

### Background Art

An organic electroluminescent (EL) element is configured to include a first electrode, an organic EL layer, and a second electrode. The organic EL element is fabricated by sequentially laminating each of constituents that constitute the element.

The organic EL layer constituting part of the organic EL element can be formed by a coating method. For example, it is possible to form the organic EL layer by applying coating liquid containing material to be an organic EL layer to make a film thereof by a predetermined coating method, and further solidifying the film.

As the method of applying the coating liquid, there are various methods. One of them is a capillary coating method utilizing a capillary phenomenon. In the capillary coating method, a coating liquid is applied to a body-to-be-coated by arranging a nozzle discharging the coating liquid upward below the body-to-be-coated, bringing the coating liquid discharged from the nozzle in contact with the body-to-be-coated and further, while maintaining a state of the coating liquid being in contact with the body-to-be-coated, moving the nozzle or the body-to-be-coated (see Patent Literature 1, for example).

### Citation List

### Patent Literature

[Patent Literature 1] Japanese Patent Application Laid-Open Publication No. 2004-164873.

### Summary of Invention

### Technical Problem

Emission intensity of an organic EL element depends on film thickness of an organic EL layer and thus, if unevenness develops in the film thickness when forming the organic EL layer, brightness unevenness occurs due to the unevenness in the film thickness. Accordingly, it is required to form the organic EL layer such that the film thickness thereof becomes uniform. However, it is difficult to obtain a coated film having a uniform film thickness by a capillary coating method, and the film thickness particularly near a position where the coating liquid is brought in contact with a body-to-be-coated tends to become larger than those in other positions.

Therefore, an object of the present invention is to provide a manufacturing method of a light-emitting device that makes it possible to form an organic EL layer in which unevenness of the film thickness thereof is suppressed by a capillary coating method.

### Solution to Problem

The present invention relates to a manufacturing method of a light-emitting device that includes a support substrate and an organic EL element provided on the support substrate. The organic EL element is configured by laminating a first electrode, an organic EL layer, and a second electrode in this order on the support substrate. The manufacturing method includes the steps of bringing a nozzle that is communicated with a tank for storing coating liquid to be the organic EL layer and discharges the coating liquid supplied from the tank near a body-to-be-coated that includes the support substrate arranged above the nozzle; bringing the coating liquid discharged from the nozzle in contact with the body-to-be-coated; and applying the coating liquid to make a film thereof by relatively moving the body-to-be-coated and the nozzle in a state that the coating liquid is in contact with the body-to-be-coated to form the organic EL layer. After bringing the coating liquid in contact with the body-to-be-coated and before relatively moving the body-to-be-coated and the nozzle, while maintaining the state that the coating liquid is in contact with the body-to-be-coated, the tank is lowered to below a position of the tank for relative movement between the body-to-be-coated and the nozzle to be started, and then the tank is raised back to the position of the tank for the relative movement between the body-to-be-coated and the nozzle to be started.

In addition, the present invention relates to the manufacturing method of the light-emitting device, in which when the coating liquid is to be detached, the nozzle is lowered after the tank is lowered, and then the coating liquid is detached.

In addition, the present invention relates to the manufacturing method of the light-emitting device, in which the coating liquid contains a low-boiling solvent whose boiling point is lower than 170°C.

In addition, the present invention relates to the manufacturing method of the light-emitting device, in which the coating liquid contains a low-boiling solvent whose boiling point is lower than 170°C at 30 wt% to 50 wt% based on the total weight.

### Advantageous Effects of Invention

According to the present invention, it is possible to form an organic EL layer in which unevenness in film thickness is suppressed by a capillary coating method.

### Brief Description of Drawings

[Fig. 1] Fig. 1 is a diagram schematically illustrating a cap coater system 11.
[Fig. 2] Fig. 2 is a side view of a nozzle 13.
[Fig. 3] Fig. 3 is a sectional diagram of the nozzle 13 along the sectional line III-III in Fig. 2.
[Fig. 4] Fig. 4 is a sectional diagram of the nozzle 13 along the sectional line IV-IV in Fig. 3.
[Fig. 5] Fig. 5 is a time chart depicting operation of the cap coater system 11.
[Fig. 6] Fig. 6 is a graph illustrating film thickness of a coated film.
[Fig. 7] Fig. 7 is a graph illustrating film thickness of a coated film.
[Fig. 8] Fig. 8 is a graph illustrating film thickness of a coated film.
[Fig. 9] Fig. 9 is a graph illustrating film thickness of a coated film.
[Fig. 10] Fig. 10 is a graph illustrating film thickness of a coated film.

### Description of Embodiments

A manufacturing method of a light-emitting device of the present invention is a manufacturing method of a light-emitting device that includes a support substrate and an organic EL element provided on the support substrate. The organic EL element is configured by laminating a first electrode, an organic EL layer, and a second electrode in this order on the support substrate. The manufacturing method includes the steps of bringing a nozzle that is communicated with a tank for storing coating liquid to be the organic EL layer and discharges the coating liquid supplied from the tank near a body-to-be-coated that includes the support substrate arranged above the nozzle; bringing the coating liquid discharged from the nozzle in contact with the body-to-be-coated; and applying the coating liquid to make a film thereof by relatively moving the body-to-be-coated and the nozzle in a state that the coating liquid is in contact with the body-to-be-coated to form the organic EL layer. After bringing the coating liquid in contact with the body-to-be-coated and before relatively moving the body-to-be-coated and the nozzle, while maintaining the state that the coating liquid is in contact with the body-to-be-coated, the tank is lowered to below a position of the tank for relative movement between the body-to-be-coated and the nozzle to be started, and then the tank is raised back to the position of the tank for the relative movement between the body-to-be-coated and the nozzle to be started. In the present specification, the expression "the state that the coating liquid is in contact with the body-to-be-coated" means a state that coating liquid attaches to the body-to-be-coated.

The organic EL element according to the present embodiment is configured by laminating the first electrode, the organic EL layer, and the second electrode in this order on the support substrate.

The first electrode and the second electrode constitute a pair of electrodes composed of an anode and a cathode. More specifically, one of the first electrode and the second electrode is provided as the anode, and the other is provided as the cathode. In addition, the first electrode out of the first electrode and the second electrode is arranged near the support substrate, and the second electrode is arranged further apart from the support substrate than the first electrode.

The organic EL element includes one or more organic EL layers. Note that the organic EL layers represent all layers interposed between the first electrode and the second electrode. The organic EL elements include at least one or more light-emitting layers as the organic EL layers. In addition, between the electrodes, without being limited to light-emitting layers, predetermined layers are provided as necessary. For example, between the anode and the light-emitting layers, as organic EL layers, a hole injection layer, a hole transport layer, an electron-blocking layer, and the like are provided, and between the light-emitting layers and the cathode, as organic EL layers, a hole-blocking layer, an electron transport layer, an electron injection layer, and the like are provided.

The organic EL element of the present embodiment includes a hole injection layer as an organic EL layer between the first electrode and these light-emitting layers. Hereinafter, as one embodiment, the organic EL element configured by laminating the first electrode functioning as an anode, the hole injection layer, the light-emitting layers, and the second electrode functioning as a cathode in this order on the support substrate will be described.

To begin with, the support substrate is prepared. The support substrate is configured with a glass plate, a resin film, and a laminate of these, for example. Note that when providing on the support substrate an organic EL element of a so-called bottom emission type in which light exiting from the organic EL element passes through the support substrate and exits to outside, the support substrate includes a material exhibiting optical transparency.

Next, the first electrode in a predetermined pattern on the support substrate is formed. For example, form the first electrode in a rectangular shape. A structure of the first electrode and a forming method thereof will be described later.

Next, the hole injection layer on the first electrode is formed. There is no limitation in particular in a forming method of the hole injection layer, but similarly to a light-emitting layer described later, for example, the hole injection layer can be formed by a coating method.

Next, the light-emitting layer as an organic EL layer is formed. In the present embodiment, the light-emitting layer is formed by a capillary coating method. More specifically, the nozzle that is communicated with the tank for storing the coating liquid to be the organic EL layer (light-emitting layer in the present embodiment) and discharges the coating liquid supplied from the tank is brought near the body-to-be-coated that includes the support substrate arranged above the nozzle, the coating liquid discharged from the nozzle is brought in contact with the body-to-be-coated, and the coating liquid to make a film thereof is applied by relatively moving the body-to-be-coated and the nozzle in the state that the coating liquid is in contact with the body-to-be-coated to form the organic EL layer. In the capillary coating method, the coating liquid is discharged upward from the nozzle by utilizing capillary force and static pressure. Note that the body-to-be-coated in the present step corresponds to the support substrate on which the first electrode and the hole injection layer are formed. For example, it is possible to form an organic EL layer having a film thickness of 5 nanometers to 200 nanometers by the capillary coating method.

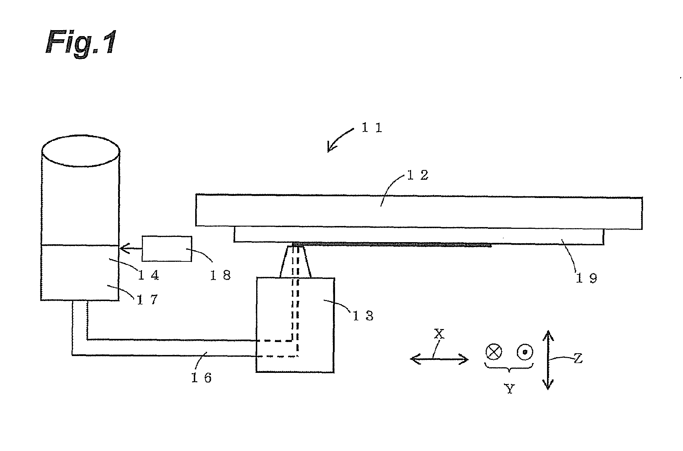

Fig. 1 is a diagram schematically illustrating a cap coater system 11 used for forming the light-emitting layer. Hereinafter, in the present specification, the terms "above" and "below" mean "above in the vertical direction" and "below in the vertical direction", respectively. Hereinafter, based on arrangement for applying the coating liquid, a structure of the cap coating system 11 will be described.

The cap coater system 11 is configured to mainly include a platen 12, a nozzle 13, and a tank 14. The platen 12 holds a body-to-be-coated 19 to be placed on its lower main surface. The platen 12 holds the body-to-be-coated 19 by vacuum suction, for example. The platen 12 reciprocates in the horizontal direction by displacement driving means not depicted such as an electric motor and a hydraulic device. Hereinafter, a moving direction of the platen 12 is also referred to as a coating direction X.

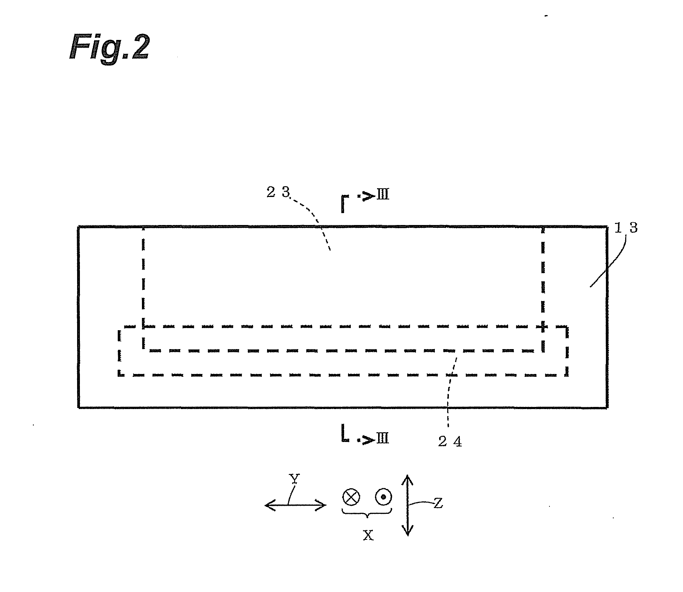

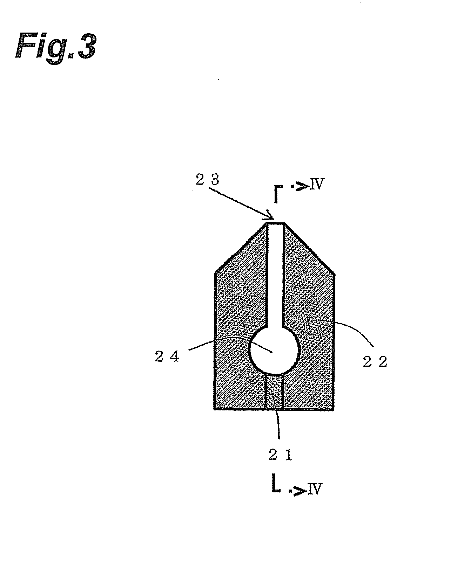

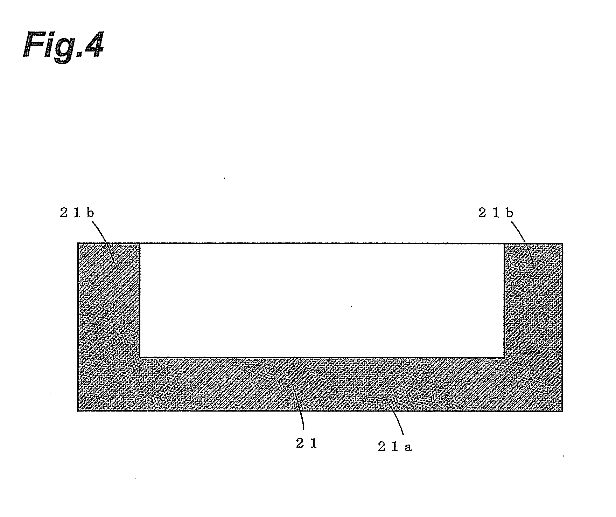

Fig. 2 is a side view of the nozzle 13. Fig. 3 is a sectional diagram of the nozzle 13 along the sectional line III-III in Fig. 2. Fig. 4 is a sectional diagram of the nozzle 13 along the sectional line IV-IV in Fig. 3. The nozzle 13 includes a slit-shaped outlet 23 that discharges the coating liquid.

As depicted in Fig. 2 to Fig. 4, the nozzle 13 is in a substantially plate-like shape, and mainly has a shim 21 and a pair of holding bodies 22 having the shim 21 interposed therebetween. The shim 21 functions as a spacer for the holding bodies 22. The space between the pair of holding bodies 22 is defined by the thickness of the shim 21 interposed therebetween. Furthermore, the width of the slit-shaped outlet 23 in the lateral direction (corresponding to the coating direction X in the present embodiment) is defined by the space between the pair of the holding bodies 22. Therefore, the width of the slit-shaped outlet 23 in the lateral direction is defined by the thickness of the shim 21. The width of the slit-shaped outlet 23 in the lateral direction is appropriately set depending on properties of the coating liquid, thickness of a coated film, and other conditions, and is generally about 0.01 millimeter to 1 millimeter. This width can be adjusted by changing the thickness of the shim 21.

Columnar concave portions each having a semicircle at the bottoms are formed, extending in a width direction Y, in the respective pair of the holding bodies 22. Note that the width direction Y represents a direction perpendicular to the coating direction X and also a direction perpendicular to the vertical direction Z. When the pair of holding bodies 22 are attached together, a cylindrical cavity is formed by the above-described columnar concave portions each having a semicircular at the bottoms. This cylindrical cavity extends in the width direction Y, and the axial center thereof corresponds to the attached surface. When the pair of the holding bodies 22 are attached together with the shim 21 interposed therebetween, the cavity formed by these two concave portions functions as a manifold 24.

The nozzle 13 is arranged so that the longitudinal direction of the slit-shaped outlet 23 corresponds to the width direction Y The slit-shaped outlet 23 is formed from the top end of the nozzle 13 to the manifold 24, and is communicated with the manifold 24. Because the manifold 24 is filled with the coating liquid, the coating liquid is supplied from the manifold 24 to the slit-shaped outlet 23. The width of the slit-shaped outlet 23 in the longitudinal direction (width direction Y) is set to the width of the coated film in the width direction Y, and is 10 millimeters to 300 millimeters, for example.

As described above, the width of the slit-shaped outlet 23 in the lateral direction is defined by the thickness of the shim 21 and, in the present embodiment, not only the width in the lateral direction (coating direction X) but also the width of the slit-shaped outlet 23 in the longitudinal direction (width direction Y) is defined by the shim 21. The shim 21 in the present embodiment, as depicted in Fig. 4, includes a plate body 21 a extending in the width direction Y directly below the manifold 24 and non-liquid feeding portions 21b extending upward from both end portions of the plate body 21 a in the width direction Y An area interposed by the non-liquid feeding portions 21b corresponds to the slit-shaped outlet 23.

The nozzle 13 is movably supported in the vertical direction Z, and is moved in the vertical direction Z by displacement driving means such as an electric motor and a hydraulic device.

The tank 14 stores therein the coating liquid 17. In the tank 14, the coating liquid 17 to be applied on the body-to-be-coated 19 is stored. In the present embodiment, liquid containing organic material to be the light-emitting layer is stored in the tank 14. The manifold 24 of the nozzle 13 and the tank 14 are communicated with each other via a coating liquid feed pipe 16. In other words, the coating liquid 17 stored in the tank 14 is supplied to the manifold 24 through the coating liquid feed pipe 16, and further applied on the body-to-be-coated 19 via the slit-shaped outlet 23. The tank 14 is movably supported in the vertical direction Z, and is moved in the vertical direction Z by the displacement driving means such as an electric motor and a hydraulic device. The tank 14 further includes a liquid level sensor 18 for detecting the liquid level of the coating liquid 17. With this liquid level sensor 18, the height of the liquid level of the coating liquid 17 in the vertical direction Z is detected. The liquid level sensor 18 includes an optical sensor or an ultrasonic vibration sensor, for example.

The coating liquid 17 supplied from the tank 14 to the slit-shaped outlet 23 through the coating liquid feed pipe 16 is extruded from the slit-shaped outlet 23 depending on pressure (static pressure) generated by the height of the liquid level in the tank 14 and force due to capillarity occurring at the slit-shaped outlet 23. Therefore, by controlling the relative difference between a liquid level position in the tank 14 and a liquid level position in the nozzle 13, it is possible to control the amount of the coating liquid extruded from the slit-shaped outlet 23. Note that the liquid level position in the tank 14 can be controlled by adjusting the vertical position of the tank 14 and accordingly, by adjusting each of the vertical positions of the nozzle 13 and the tank 14, it is possible to control the amount of the coating liquid extruded from the slit-shaped outlet 23.

The cap coater system 11 further includes a controller including a microcomputer and the like, and this controller controls the displacement driving means described above and the like. The controller controls the displacement driving means, whereby the positions of the nozzle 13 and the tank 14 in the vertical direction Z and the displacement of the platen 12 in the coating direction X are controlled. When applying the coating liquid 17, the coating liquid 17 is consumed and accordingly the liquid level of the coating liquid 17 in the tank 14 falls with time. However, the controller controls the displacement driving means based on detection results of the liquid level sensor 18 to adjust the position of the tank 14 in the vertical direction Z, making it possible to control the height of the coating liquid 17 to be extruded from the slit-shaped outlet 23.

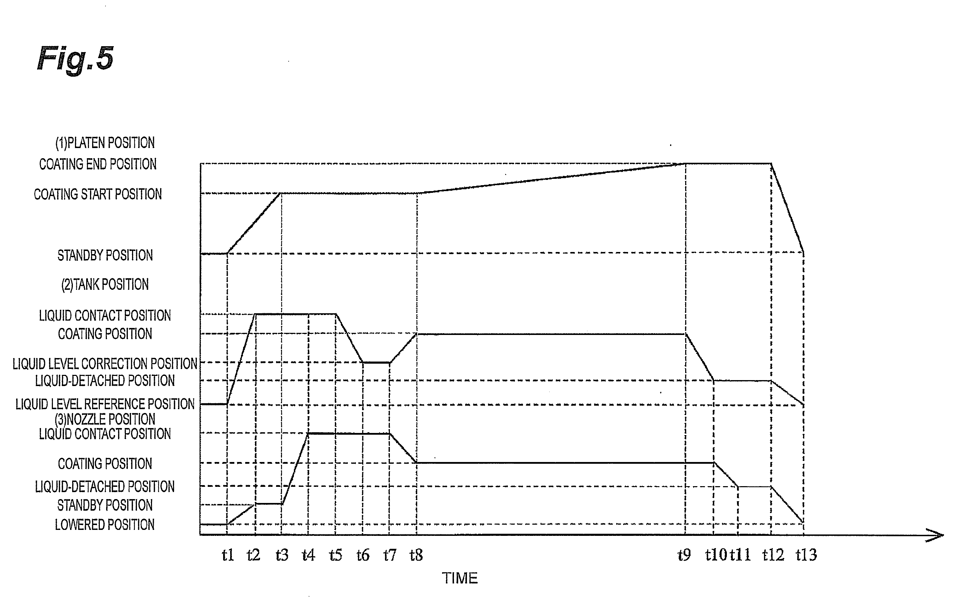

Hereinafter, operation of the cap coater system 11 when applying the coating liquid will be described with reference to Fig. 5. Fig. 5 is a time chart depicting the operation of the cap coater system 11. The abscissa in Fig. 5 represents the lapse of time.

When coating is to be started, the platen 12 holding the body-to-be-coated is arranged at a standby position to the left side of a coating start position, the tank 14 is arranged at a liquid level reference position, and the nozzle 13 is arranged at a lowered position. At this time, the nozzle is in a state that the coating liquid is not discharged therefrom.

<t1 to t4> The coating liquid is brought in contact with the body-to-be-coated.
The platen 12 moves from the standby position to the coating start position from time t1 through time t3. Subsequently, the platen 12 is at standstill at the coating start position until time t8 when coating is started.

The tank 14 moves from the liquid level reference position to a liquid contact position from time t1 through time t2. The tank 14 moves to the liquid contact position in this manner, whereby the nozzle is in a state that the coating liquid is discharged from the slit-shaped outlet 23. Note that the liquid contact position of the tank is positioned at 1 millimeter to 50 millimeters above a coating position described later.

Meanwhile, the nozzle 13 is raised from the lowered position to the standby position from time t1 through time t2. Subsequently, the nozzle 13 is raised from the standby position to the liquid contact position from time t3 through time t4. Note that the nozzle 13 approaches the body-to-be-coated while being in the state that the coating liquid is discharged from the slit-shaped outlet 23, and accordingly immediately before time t4, the coating liquid comes in contact with the body-to-be-coated 19. At the liquid contact position of the nozzle 13, a space between the upper end of the nozzle 13 and the body-to-be-coated 19 is 3 micrometers to 30 micrometers, for example.

<t4 to t8> The amount of the coating liquid being in contact with the body-to-be-coated is adjusted.
After the coating liquid comes in contact with the body-to-be-coated 19, the tank 14 is lowered from the liquid contact position to a liquid level correction position from time t5 through time t6. Note that the tank 14 is lowered while maintaining the state that the coating liquid is in contact. The liquid level correction position is positioned at 1 millimeter to 20 millimeters below a coating position described later. In this manner, the tank 14 is once lowered to below the coating position, and then is raised from the liquid level correction position to the coating position from time t7 through time t8.

As described above, in the present embodiment, after bringing the coating liquid in contact and before relatively moving the body-to-be-coated and the nozzle, while maintaining the state the coating liquid is in contact, the tank is lowered to below the position of the tank for the relative movement of the body-to-be-coated and the nozzle to be started, and then the tank is raised back to the position of the tank for the relative movement of the body-to-be-coated and the nozzle to be started.

By lowering the tank 14 once to below the coating position, it is possible to bring part of the coating liquid present between the top end of the nozzle 13 and the body-to-be-coated 19 back into the slit-shaped outlet 23. In other words, it is possible to adjust the amount of the coating liquid being in contact with the body-to-be-coated. In this manner, by adjusting the amount of coating liquid being in contact with the body-to-be-coated, it is possible to adjust the film thickness of the coated film at the start of coating. Accordingly, it is possible to suppress thickening of the coated film at the start of coating.

The nozzle 13 is lowered from the liquid contact position to the coating position from time t7 through time t8. The space between the top end of the nozzle 13 and the body-to-be-coated 19 at time t8 is about 30 micrometers to 300 micrometers.

<t8 to t9> The coating liquid is applied.
The coating liquid is applied to the body-to-be-coated from time t8 through time t9. The platen 12 moves toward the right from the coating start position to a coating end position from time t8 through time t9. Because the platen moves while maintaining the state that the coating liquid is in contact with the body-to-be-coated, the coating liquid is applied to the body-to-be-coated. The moving speed of the platen 12 is 0.1 m/min to 5 m/min, for example.

In the present embodiment, from time t8 through time t9, the positions of the nozzle 13 and the tank 14 remain unchanged. Note that it is acceptable to raise the tank at a predetermined speed from time t8 through time t9. Because the coating liquid is applied to the body-to-be-coated from time t8 through time t9, the ink is consumed and there are occasions when the height of the liquid level of the coating liquid in the tank 14 falls, but it is possible to keep the height of the liquid level of the coating liquid in the tank 14 constant by raising the tank 14 at the predetermined speed from time t8 through time t9, for example.

<t9 to t12> The coating liquid is detached.
The tank 14 is lowered to a liquid-detached position from time t9 through time t10. The distance the tank 14 is lowered from time t9 through time t10 is about 1 millimeter to 20 millimeters. Note that in the present embodiment, the tank 14 is lowered to the liquid-detached position while maintaining the state that the coating liquid is in contact with the body-to-be-coated. The tank 14 is lowered in this manner, whereby it is possible to bring part of the coating liquid present between the top end of the nozzle 13 and the body-to-be-coated 19 back into the slit-shaped outlet 23. Subsequently, the nozzle 13 is lowered to the liquid-detached position from time t10 through time t11. The nozzle 13 is lowered in this manner, whereby the coating liquid is detached from the body-to-be-coated.

As described above, to detach the coating liquid, lower the nozzle after lowering the tank. By bringing part of the coating liquid present between the top end of the nozzle 13 and the body-to-be-coated 19 back into the slit-shaped outlet 23, and then lowering the nozzle to detach the coating liquid, it is possible to suppress thickening of the coated film at the coating end position.

After detaching the coating liquid, from t12 through t13, the platen 12 moves to the standby position, the tank 14 moves to the liquid level reference position, and the nozzle 13 moves to the lowered position, whereby the coating of the coating liquid is ended.

Note that in the present embodiment, the platen 12 is assumed to move to the standby position from t12 through t13, but alternatively, it is acceptable to move the platen 12 further to the right from t12 through t13 and, setting this as a new standby position, to newly repeat the operation from t1 through t13, and also it is acceptable to repeat this operation for a plurality of times.

By performing the operation from t1 to t13 as described above, it is possible to apply the coating liquid.

As described above, in the period from time t5 to time t8, by lowering the tank 14 once to below the coating position, after adjusting the amount of the coating liquid, the coating liquid is applied, and accordingly it is possible to adjust the film thickness of the coated film at the start of coating to form the coated film having an even film thickness.

In addition, in the period from time t9 to time t11, when detaching the coating liquid, by lowering the nozzle after lowering the tank, the nozzle is lowered after part of the coating liquid is brought back into the slit-shaped outlet 23, and the coating liquid is detached, making it possible to suppress thickening of the coated film at the coating end position. Accordingly, it is possible to adjust the film thickness of the coated film at the end of coating to form the coated film having an even film thickness.

The coating liquid contains material to be an organic EL layer (organic material to be the light-emitting layer in the present embodiment) and a solvent. As the solvent of the coating liquid, it is acceptable to use one type of solvent exhibiting a specified boiling point alone, or to use a plurality of types of solvents in combination. As the solvent constituting the coating liquid of the present invention, one that dissolves material to be a layer to be formed (organic material to be the light-emitting layer in the present embodiment) is desirable, and such a solvent is exemplified below. More specifically, examples of the solvent constituting the coating liquid include aliphatic chlorine solvents such as chloroform (bp 61°C), methylene chloride (bp 40°C), 1,1-dichloroethane (bp 57°C), 1,2-dichloloethane (bp 83°C), 1,1,1-trichloroethane (bp 74°C), and 1,1,2-trichloroethane (bp 113°C); aromatic chlorine solvents such as chlorobenzene (bp 132°C), o-dichlorobenzene (bp 180°C), m-dichlorobenzene (bp 173°C), and p-dichlorobenzene (bp 174°C); aliphatic ether solvents such as tetrahydrofuran (bp 66°C) and 1,4-dioxane (bp 101 °C); aromatic ether solvents such as anisole (bp 154°C) and ethoxybenzene (bp 170°C); aromatic hydrocarbon solvents such as toluene (bp 111°C), o-xylene (bp 144°C), m-xylene (bp 139°C), p-xylene (bp 138°C), ethylbenzene (bp 136°C), p-diethylbenzene (bp 184°C), mesitylene (bp 211°C), n-propylbenzene (bp159°C), isopropylbenzene (bp 152°C), n-butylbenzene (bp 183°C), isobutylbenzene (bp 173°C), s-butylbenzene (bp 173°C), tetralin (bp 208°C), and cyclohexylbenzene (bp 235°C: measured at 737 mmHg); aliphatic hydrocarbon solvents such as cyclohexane (bp 81°C), methylcyclohexane (bp 101°C), n-pentane (bp 36°C), n-hexane (bp 69°C), n-heptane (bp 98°C), n-octane (bp 126°C), n-nonane (bp 151°C), n-decane (bp 174°C), decalin (the cis form has a boiling point of 196°C, and the trans form has a boiling point of 187°C), and bicyclohexyl (bp 217°C to 233°C); aliphatic ketone solvents such as acetone (bp 56°C), methyl ethyl ketone (bp 80°C), methyl isobutyl ketone (bp 117°C), cyclohexanone (bp 156°C), 2-heptanone (bp 150°C), 3-heptanone (bp 147°C: measured at 765 mmHg), 4-heptanone (bp 144°C), 2-octanone (bp 174°C), 2-nonanone (bp 195°C), and 2-decanone (bp 209°C); aromatic ketone solvents such as acetophenone (bp 202°C); aliphatic ester solvents such as ethyl acetate (bp 77°C) and butyl acetate (bp 120°C to 125°C); aromatic ester solvents such as methyl benzoate (bp 200°C), butyl benzoate (bp 213°C), and phenyl acetate (bp 196°C); aliphatic polyhydric alcohol solvents and solvents of derivatives of aliphatic polyhydric alcohol such as ethylene glycol (bp 198°C), ethylene glycol monobutyl ether (bp 171°C), ethylene glycol monoethyl ether (bp 135°C), ethylene glycol monomethyl ether (bp 125°C), 1,2-dimethoxyethane (bp 85°C), propylene glycol (bp 188°C), 1,2-diethoxymethane (bp 124°C), triethylene glycol diethyl ether (bp 222°C), and 2,5-hexanediol (bp 218°C); aliphatic alcohol solvents such as methanol (bp 65°C), ethanol (bp 78°C), propanol (bp 97°C), isopropanol (bp 82°C), and cyclohexanol (bp 161°C); aliphatic sulfoxide solvents such as dimethylsulfoxide (bp 37°C); and aliphatic amide solvents such as N-methyl-2-pyrrolidone (bp 202°C) and N,N-dimethylformamide (bp 153°C).

The coating liquid is preferred to contain a low-boiling solvent whose boiling point is lower than 170°C. As the low-boiling solvent whose boiling point is lower than 170°C, it is possible to use the above-recited solvents, and among these, o-xylene, m-xylene, p-xylene, and a mixed solvent thereof and anisole are preferred.

The coating liquid is preferred to contain a low-boiling solvent whose boiling point is lower than 170°C at 30 wt% to 50 wt% based on the total weight. By using such a coating liquid, it is possible to form a coated film having a more uniform film thickness.

Next, form the light-emitting layer by solidifying the coated film thus applied. The coated film can be solidified by removing the solvent. Removal of the solvent can be performed by natural drying or drying by heating. In addition, when using a coating liquid containing a polymerizable compound, it is acceptable to solidify the coated liquid by applying heat or radiating light to the coated film.

Next, by forming the second electrode on this light-emitting layer, it is possible to form the organic EL element.

### <Structure of Organic EL Element>

The organic EL element can have various layer structures as described above, and a layer structure of the organic EL element, a structure of each layer, and a forming method of each layer will be described in more detail below.

As described above, an organic EL element is configured to include a pair of electrodes composed of an anode and a cathode (the first and second electrodes) and one or more organic EL layers provided between the electrodes, and has at least one light-emitting layer as the one or more organic EL layers. Note that the organic EL element may include a layer containing an inorganic substance and an organic substance, an inorganic layer, and the like. The organic substance constituting the organic layers may be a low-molecular-weight compound or a polymer compound, and also may be a mixture of a low-molecular-weight compound and a polymer compound. The organic layers preferably contain a polymer compound, and preferably contain a polymer compound having a number average molecular weight of 10³ to 10⁸ in terms of polystyrene.

Examples of the organic EL layers provided between the cathode and the light-emitting layer include an electron injection layer, an electron transport layer, and a hole-blocking layer. When both of the electron injection layer and the electron transport layer are provided between the cathode and the light-emitting layer, the layer close to the cathode is referred to as the electron injection layer, and the layer close to the light-emitting layer is referred to as the electron transport layer. Examples of the organic EL layers provided between the anode and the light-emitting layer include a hole injection layer, a hole transport layer, and an electron-blocking layer. When both of the hole injection layer and the hole transport layer are provided, the layer close to the anode is referred to as the hole injection layer, and the layer close to the light-emitting layer is referred to as the hole transport layer.

Examples of possible layer structures of the organic EL element of the present embodiment are listed below.
a) anode / light-emitting layer / cathode
b) anode / hole injection layer / light-emitting layer / cathode
c) anode / hole injection layer / light-emitting layer / electron injection layer / cathode
d) anode / hole injection layer / light-emitting layer / electron transport layer / cathode
e) anode / hole injection layer / light-emitting layer / electron transport layer / electron injection layer / cathode
f) anode / hole transport layer / light-emitting layer / cathode
g) anode / hole transport layer / light-emitting layer / electron injection layer / cathode
h) anode / hole transport layer / light-emitting layer / electron transport layer / cathode
i) anode / hole transport layer / light-emitting layer / electron transport layer / electron injection layer / cathode
j) anode / hole injection layer / hole transport layer / light-emitting layer / cathode
k) anode / hole injection layer / hole transport layer / light-emitting layer / electron injection layer / cathode
l) anode / hole injection layer / hole transport layer / light-emitting layer / electron transport layer / cathode
m) anode / hole injection layer / hole transport layer / light-emitting layer / electron transport layer / electron injection layer / cathode
n) anode / light-emitting layer / electron injection layer / cathode
o) anode / light-emitting layer / electron transport layer / cathode
p) anode / light-emitting layer / electron transport layer / electron injection layer / cathode
(Here, the mark "/" indicates that the respective layers sandwiching the mark "/" are laminated adjacent to each other. The same applies hereinafter.)

The organic EL element of the present embodiment may have two or more light-emitting layers. In any one of the layer structures a) to p) listed above, when referring to a laminate held between the anode and the cathode as a "structural unit A", examples of a structure of the organic EL element having two light-emitting layers include the layer structure indicated in q) below. Note that the layer structures of the (structural unit A) appearing twice may be the same or different from each other.
q) anode / (structural unit A) / charge-generating layer / (structural unit A) / cathode

In addition, when referring to the "(structural unit A) /charge-generating layer" as a "structural unit B", examples of a structure of the organic EL element having three or more light-emitting layers include the layer structure indicated in r) below.
r) anode / (structural unit B)x / (structural unit A) / cathode

Note that the mark "x" indicates an integer equal to or more than two, and (structural unit B)x indicates a laminate with x layers of structural unit B being laminated. Layer structures of a plurality of (structural unit B) may be the same or different from each other.

Here, the charge-generating layer is a layer that generates holes and electrons by applying an electric field. Examples of the charge-generating layer include a thin film made of, for example, vanadium oxide, indium tin oxide (ITO), or molybdenum oxide.

It is acceptable to provide the organic EL element with the anode out of the pair of electrodes composed of the anode and the cathode arranged nearer the support substrate than the cathode on the support substrate, or it is acceptable to provide the organic EL element with the cathode arranged nearer the support substrate than the anode on the support substrate. For example, in the above-listed a) to r), it is acceptable to laminate the respective layers in order from the right on the support substrate to constitute the organic EL element, or it is acceptable to laminate the respective layers in order from the left on the support substrate to constitute the organic EL element. It is possible to appropriately set order of layers to be laminated, the number of the layers, and thicknesses of the respective layers in consideration of light emission efficiency or the product life of the element.

Materials of the respective layers constituting the organic EL element and a forming method thereof will be described more specifically below.

### <Anode>

For the organic EL element having a structure in which light emitted from the light-emitting layer exits through the anode to the outside of the element, an electrode exhibiting optical transparency is used for the anode. As the electrode exhibiting optical transparency, a thin film of metal oxide, metal sulfide, metal, and the like is usable, and one having high electric conductivity and high optical transparency is preferably used. More specifically, a thin film made of indium oxide, zinc oxide, tin oxide, ITO, indium zinc oxide (IZO), gold, silver, platinum, or copper is used, and among these, a thin film made of ITO, IZO, or tin oxide is preferably used.

Examples of a production method of the anode include a vacuum deposition method, a sputtering method, an ion plating method, and a plating method. Alternatively, as the anode, it is acceptable to use an organic transparent conductive film such as polyaniline or derivatives thereof and polythiophene or derivatives thereof.

The film thickness of the anode is appropriately set in view of required properties, simplicity of the film forming process, and other conditions, and is 10 nanometers to 10 micrometers, for example, preferably 20 nanometers to 1 micrometer, and more preferably 50 nanometers to 500 nanometers.

### <Cathode>

As material for the cathode, one that has a small work function, facilitates electron injection into the light-emitting layer, and has high electric conductivity is preferable. In addition, for the organic EL element configured to extract light from the anode side, in which light emitted from the light-emitting layer is reflected by the cathode to the anode side, material having high reflectivity to visible light is preferable as material for the cathode. For the cathode, for example, an alkali metal, an alkali earth metal, a transition metal, or a metal of Group 13 of the periodic table is usable. Examples of the material for the cathode may include metals such as lithium, sodium, potassium, rubidium, cesium, beryllium, magnesium, calcium, strontium, barium, aluminum, scandium, vanadium, zinc, yttrium, indium, cerium, samarium, europium, terbium, and ytterbium, an alloy of two or more of the metals, an alloy of one or more of the metals and one or more of gold, silver, platinum, copper, manganese, titanium, cobalt, nickel, tungsten, and tin, and graphite or a graphite interlayer compound. Examples of the alloys include magnesium-silver alloy, magnesium-indium alloy, magnesium-aluminum alloy, indium-silver alloy, lithium-aluminum alloy, lithium-magnesium alloy, lithium-indium alloy, and calcium-aluminum alloy. In addition, as the cathode, it is possible to use a transparent conductive electrode made of conductive metal oxide, a conductive organic substance, and the like. More specifically, examples of the conductive metal oxide include indium oxide, zinc oxide, tin oxide, ITO, and IZO, and examples of the conductive organic substance include polyaniline or derivatives thereof, and polythiophene or derivatives thereof. Noted that the cathode may be configured with a laminate with two or more layers laminated. Also, the electron injection layer may be used as the cathode in some cases.

The film thickness of the cathode is appropriately set in view of required properties, simplicity of the film forming process, and other conditions, and is 10 nanometers to 10 micrometers, for example, preferably 20 nanometers to 1 micrometer, and more preferably 50 nanometers to 500 nanometers.

Examples of a production method of the cathode include a vacuum deposition method, a sputtering method, and a lamination method of performing thermocompression bonding of a metal thin film.

### <Hole Injection Layer>

Examples of a hole injection material constituting the hole injection layer include oxides such as vanadium oxide, molybdenum oxide, ruthenium oxide, and aluminum oxide, a phenylamine-based material, a starburst type amine-based material a phthalocyanine-based material, amorphous carbon, polyaniline, and a polythiophene derivative.

The film thickness of the hole injection layer is appropriately set in view of required properties, simplicity of the film forming process, and other conditions, and is 1 nanometer to 1 micrometer, for example, preferably 2 nanometers to 500 nanometers, and more preferably 5 nanometers to 200 nanometers.

### <Hole Transport Layer>

Examples of a hole transport material constituting the hole transport layer include polyvinylcarbazole or derivatives thereof, polysilane or derivatives thereof, a polysiloxane derivative having aromatic amine at a side chain or the main chain, a pyrazoline derivative, an arylamine derivative, a stilbene derivative, a triphenyldiamine derivative, polyaniline or derivatives thereof, polythiophene or derivatives thereof, polyarylamine or derivatives thereof, polypyrrole or derivatives thereof, poly(p-phenylenevinylene) or derivatives thereof, and poly(2,5-thienylenevinylene) or derivatives thereof.

The film thickness of the hole transport layer is set in view of required properties, simplicity of the film forming process, and other conditions, and is 1 nanometer to 1 micrometer, for example, preferably 2 nanometers to 500 nanometers, and more preferably 5 nanometers to 200 nanometers.

### <Light-Emitting Layer>

The light-emitting layer is generally formed primarily from an organic substance emitting fluorescent and/or phosphorescent light, or the organic substance and a dopant for assisting this. The dopant is added for the purpose of improving light emission efficiency or changing an emission wavelength, for example. Note that the organic substance constituting the light-emitting layer may be a low-molecular-weight compound or a polymer compound and, in the case of forming the light-emitting layer by the coating method, it is preferable that the light-emitting layer contain the polymer compound. The number average molecular weight of the polymer compound constituting the light-emitting layer in terms of polystyrene is about 10³ to 10⁸, for example. Examples of the light-emitting material constituting the light-emitting layer include a dye-based material, a metal complex-based material, a polymer-based material, and a dopant material enumerated below.

### (Dye-Based Material)

Examples of the dye-based material include a cyclopendamine derivative, a tetraphenylbutadiene derivative, a triphenylamine derivative, an oxadiazole derivative, a pyrazoloquinoline derivative, a distyrylbenzene derivative, a distyrylarylene derivative, a pyrrole derivative, a thiophene ring compound, a pyridine ring compound, a pelynone derivative, a perylene derivative, an oligothiophene derivative, an oxadiazole dimmer, a pyrazoline dimmer, a quinacridone derivative, and a coumarin derivative.

### (Metal Complex-Based Material)

Examples of the metal complex-based material include a metal complex having a rare earth metal (e.g., Tb, Eu, or Dy), Al, Zn, Be, Ir, Pt, or the like as a central metal, and having oxadiazole, thiadiazole, phenylpyridine, phenylbenzoimidazole, a quinoline structure, or the like as a ligand, and examples thereof include a metal complex emitting light from a triplet excited state such as an iridium complex and platinum complex, an aluminum quinolinol complex, a benzoquinolinol beryllium complex, a benzooxazole zinc complex, a benzothiazole zinc complex, an azomethyl zinc complex, a porphyrin zinc complex, and a phenanthroline europium complex.

### (Polymer-Based Material)

Examples of the polymer-based material include a polyparaphenylene vinylene derivative, a polythiophene derivative, a polyparaphenylene derivative, a polysilane derivative, a polyacetylene derivative, a polyfluorene derivative, a polyvinylcarbazole derivative, and those obtainable by polymerizing the dye-based material and metal complex-based light-emitting material.

The thickness of the light-emitting layer is generally about 2 nanometers to 200 nanometers.

### <Electron Transport Layer>

As an electron transport material constituting the electron transport layer, it is possible to use a publicly-known one, and examples thereof include an oxadiazole derivative, anthraquino-dimethane or derivatives thereof, benzoquinone or derivatives thereof, naphthoquinone or derivatives thereof, anthraquinone or derivatives thereof, tetracyanoanthraquino-dimethane or derivatives thereof, a fluorenone derivative, diphenyldicyanoethylene or derivatives thereof, a diphenoquinone derivative, 8-hydroxyquinoline or metal complexes of derivatives thereof, polyquinoline or derivatives thereof, polyquinoxaline or derivatives thereof, and polyfluorene or derivatives thereof.

The film thickness of the electron transport layer is appropriately set in view of required properties, simplicity of the film forming process, and other conditions, and is 1 nanometer to 1 micrometer, for example, preferably 2 nanometers to 500 nanometers, and more preferably 5 nanometers to 200 nanometers.

### <Electron Injection Layer>

As an electron injection material constituting the electron injection layer, an optimum material is appropriately selected depending on the type of the light-emitting layer, and examples thereof include an alkali metal, an alkali earth metal, an alloy containing one or more types of metals out of alkali metals and alkali earth metals, an oxide, a halide, and a carbonate of an alkali metal or an alkali earth metal, and a mixture of these substances. Examples of the alkali metal and the oxide, the halide, and the carbonate of the alkali metal include lithium, sodium, potassium, rubidium, cesium, lithium oxide, lithium fluoride, sodium oxide, sodium fluoride, potassium oxide, potassium fluoride, rubidium oxide, rubidium fluoride, cesium oxide, cesium fluoride, and lithium carbonate. In addition, examples of the alkali earth metal and the oxide, the halide, and the carbonate of the alkali earth metal include magnesium, calcium, barium, strontium, magnesium oxide, magnesium fluoride, calcium oxide, calcium fluoride, barium oxide, barium fluoride, strontium oxide, strontium fluoride, and magnesium carbonate. The electron injection layer may be constituted by a laminate that is prepared by laminating two or more layers, and examples thereof include a laminate of LiF/Ca.

The film thickness of the electron injection layer is preferably about 1 nanometer to 1 micrometer.

When among the organic EL layers there are a plurality of organic EL layers that can be formed by a coating method, it is preferable to form all of the organic EL layers by the coating method, but it is acceptable to form by the coating method at least one layer out of the organic EL layers that can be formed by the coating method, and form the other organic EL layers by a method different from the coating method. In addition, even when forming a plurality of organic EL layers by the coating method, it is acceptable to form the organic EL layers by coating methods concrete methods of which are different. For example, it is acceptable to form the hole injection layer by a spin coating method and form the light-emitting layer by a nozzle printing method.

Alternatively, as a method different from the coating methods, it is acceptable to form the organic EL layers by a vacuum deposition method, a sputtering method, a CVD method, and a lamination method.

### [Example 1]

The coating liquid was applied to a glass substrate by using a cap coater system (product name: CAP Coater III) manufactured by HIRANO TECSEED Co., Ltd. that is similar to the cap coater system 11 depicted in Fig. 1 and operating the cap coater system in the same manner as the time chart depicted in Fig. 5.

The longitudinal width of the slit-shaped outlet of the nozzle was 200 millimeters, and the lateral width thereof was 300 micrometers. The dimensions of the glass substrate were 200 millimeters x 200 millimeters x 0.7 millimeters.

As a light-emitting material, Lumation GP1300 (Green1300) manufactured by Sumation Co., Ltd. was used. As the solvent, a mixed solvent of anisole and cyclohexylbenzene (CHB), or anisole alone was used. Weight concentration of the light-emitting material and mixing ratio of the solvent in the coating liquid used for each Example and Comparative example are listed in Table 1.

**[Table 1]**

| | Light-emitting material (wt%) | Anisole . CHB (weight ratio) |
|---|---|---|
| Example 1 | 1.0 | 3:7 |
| Example 2 | 1.0 | 5:5 |
| Example 3 | 1.2 | 7:3 |
| Example 4 | 1.2 | 10:0 |
| Comparative example 1 | 1.0 | 5:5 |

With respect to the tank position for each Example, when assuming the coating position as a reference, the liquid contact position was positioned at 11 millimeters above the coating position, the liquid level correction position was positioned at 9 millimeters below the coating position, and the liquid-detached position was positioned at 11 millimeters below the coating position.

With respect to the nozzle position for each Example, at the liquid contact position, distance between the glass substrate and the top end of the nozzle was 10 micrometers and, at the coating position, distance between the glass substrate and the top end of the nozzle was 220 micrometers.

The coating speed was 0.5 m/min, and the coating distance was 70 millimeters.

### (Comparative example 1)

Without lowering the tank position from the liquid contact position to below the coating position at the start of coating, the tank position was lowered from the liquid contact position to the coating position, and the coating liquid was immediately applied. When the platen stopped in detaching the coating liquid, the tank and the nozzle were simultaneously lowered. With respect to the tank position in the present example, when assuming the coating position as a reference, the liquid contact position was positioned at 11 millimeters above the coating position, and the liquid-detached position was positioned at 17 millimeters below the coating position. Distances between the glass substrate and the top end of the nozzle at the liquid contact position and at the coating position were set in the same manner as Examples 1 to 4.

The coating speed was 0.5 m/min, and the coating distance was 190 millimeters.

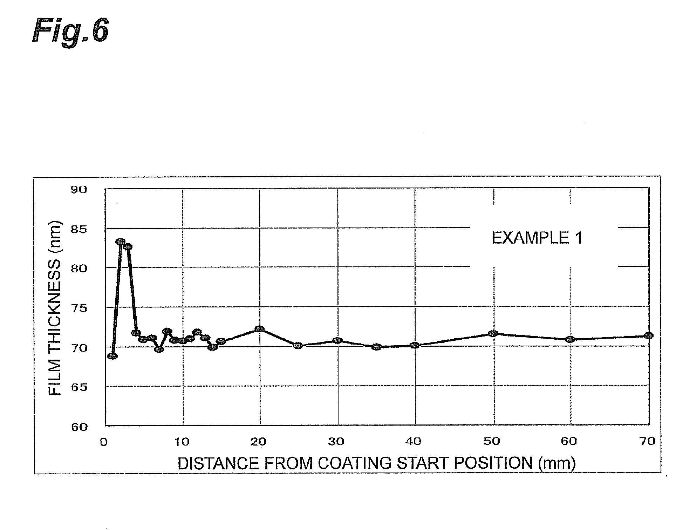

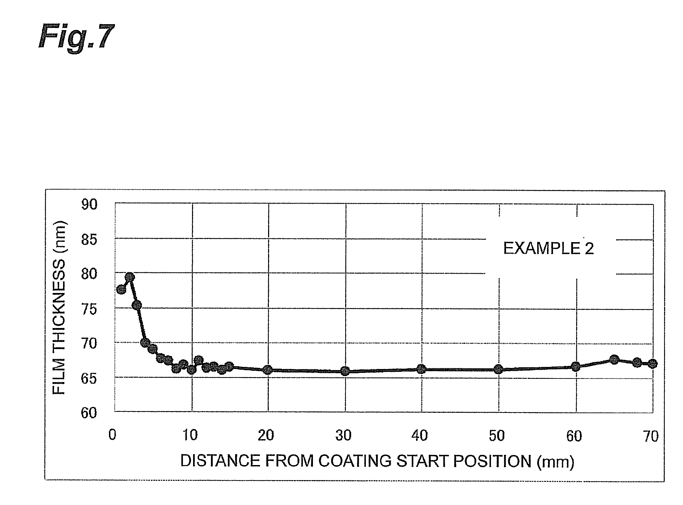

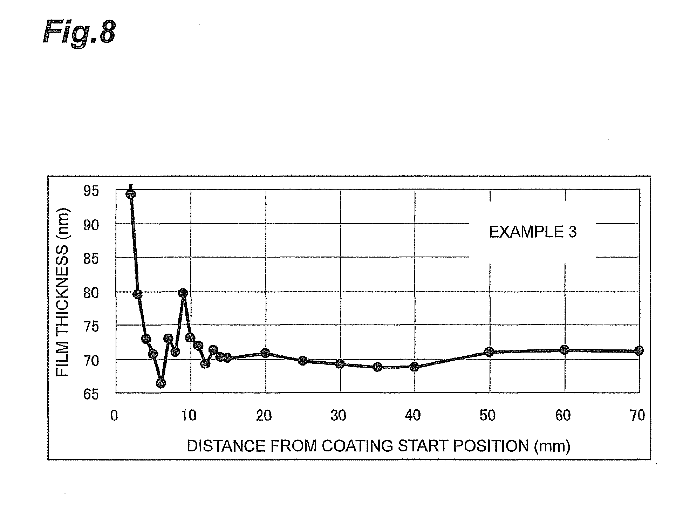

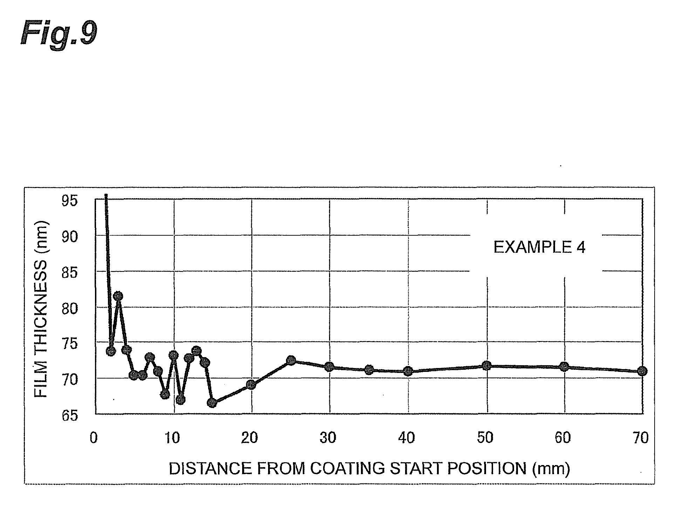

Film thicknesses of the coated films applied in Examples 1 to 4 and Comparative example 1 were measured by using a stylus film thickness meter (product name: P-16+) manufactured by TENCOR corporation. Fig. 6 to Fig. 10 illustrate the film thicknesses of the coated films. The abscissa represents the distance in the coating direction X.

As depicted in Figs. 6 to 9, by controlling the tank position before starting coating, it was observed that thick film portion of the coated film near the liquid contact position fell within about 30 millimeters from the start of coating on the glass substrate in the coating direction. Furthermore, when using the coating liquid that contains a low-boiling solvent whose boiling point is lower than 170°C at 30 wt% to 50 wt% based on the total weight, it was observed that the thick film portion of the coated film near the liquid contact position could be further shortened, and fell within about 10 millimeters from the start of coating on the glass substrate in the coating direction. In addition, by lowering the nozzle after lowering the tank when detaching the coating liquid, it is possible to suppress thickening of the coated film near the liquid-detached position.

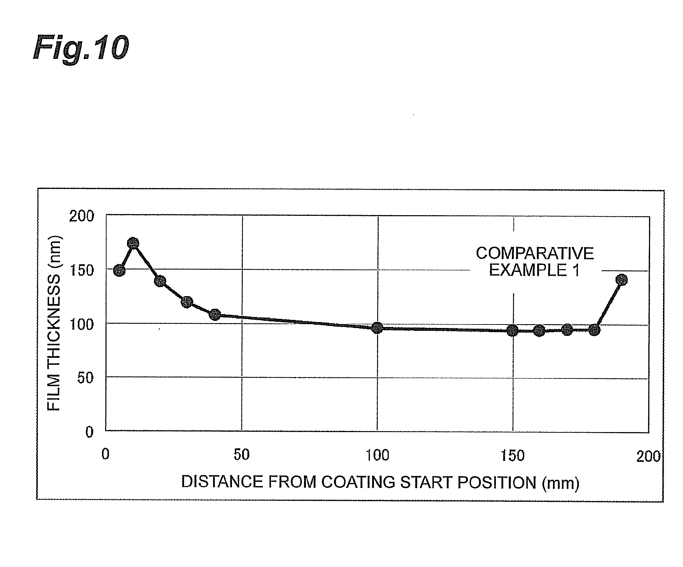

On the other hand, as depicted in Fig. 10, it was observed that without lowering the tank position from the liquid contact position to below the coating position at the start of coating, by lowering the tank position from the liquid contact position to the coating position and immediately applying the coating liquid and, at the end of coating, stopping the platen and also lowering the tank and the nozzle simultaneously, the thick film portion of the coated film near the liquid contact position developed up to a length of about 50 millimeters from the coating start position in the coating direction. In addition, it was observed that thick film portion of the coated film near the liquid-detached position developed for a length of about 10 millimeters in the coating direction.

Embodiments of the present invention have been described above, but the present invention is not limited to the above-described embodiments, and various modifications are possible.

### Industrial Applicability

With the manufacturing method of the light-emitting device of the present invention, it becomes possible to form an organic EL layer in which unevenness of the film thickness is suppressed by a capillary coating method.

### Reference Signs List

11... cap coater system, 12... platen, 13... nozzle, 14... tank, 16... coating liquid feed pipe, 17... coating liquid, 18... sensor, 19... body-to-be-coated, 21... shim, 22... holding bodies, 23... slit-shaped outlet, 24... manifold

## Claims

1. A manufacturing method of a light-emitting device that comprises a support substrate and an organic electroluminescent (EL) element provided on the support substrate, the organic EL element being configured by laminating a first electrode, an organic EL layer, and a second electrode in this order on the support substrate, the manufacturing method comprising the steps of:
bringing a nozzle that is communicated with a tank for storing coating liquid to be the organic EL layer and discharges the coating liquid supplied from the tank near a body-to-be-coated that includes the support substrate arranged above the nozzle; bringing the coating liquid discharged from the nozzle in contact with the body-to-be-coated; and applying the coating liquid to make a film thereof by relatively moving the body-to-be-coated and the nozzle in a state that the coating liquid is in contact with the body-to-be-coated to form the organic EL layer, wherein
after bringing the coating liquid in contact with the body-to-be-coated and before relatively moving the body-to-be-coated and the nozzle, while maintaining the state that the coating liquid is in contact with the body-to-be-coated, the tank is lowered to below a position of the tank for relative movement between the body-to-be-coated and the nozzle to be started, and then the tank is raised back to the position of the tank for the relative movement between the body-to-be-coated and the nozzle to be started.

2. The manufacturing method of the light-emitting device according to Claim 1, wherein when the coating liquid is to be detached, the nozzle is lowered after the tank is lowered, and then the coating liquid is detached.

3. The manufacturing method of the light-emitting device according to Claim 1 or 2, wherein the coating liquid contains a low-boiling solvent whose boiling point is lower than 170°C.

4. The manufacturing method of the light-emitting device according to any one of Claims 1 to 3, wherein the coating liquid contains a low-boiling solvent whose boiling point is lower than 170°C at 30 wt% to 50 wt% based on the total weight.
